# DEMANDE DE BREVET EUROPEEN

(11) **EP 4 060 715 A1**
(43) Date de publication de la demande: **21.09.2022**
(21) Numéro de dépôt: 22172838.9
(22) Date de dépôt: 26.03.2020
(51) Int. Cl.: H01L 21/02, H01L 21/762, H01L 21/322

(54) **UNE STRUCTURE COMPRENANT UNE COUCHE MINCE REPORTÉE SUR UN SUPPORT MUNI D'UNE COUCHE DE PIÉGEAGE DE CHARGES**

(30) Priorité: 12.07.2019 FR 1907859
(62) Demande divisionnaire de: 20712993.3
(71) Demandeur: SOITEC, 38190 Bernin (FR)
(72) Inventeur: BERTRAND, Isabelle, 38190 BERNIN (FR); DROUIN, Alexis, 38530 LA BUISSIERE (FR); HUYET, Isabelle, 38920 CROLLES (FR); BUTAUD, Eric, 38000 GRENOBLE (FR); LOGIOU, Morgane, 38920 CROLLES (FR)
(74) Mandataire: IP Trust

(57) **Abrégé**

L'invention porte sur procédé de fabrication d'une structure (1) comprenant une couche mince (5) reportée sur un support (2) muni d'une couche de piégeage de charges (3), le procédé comprenant les étapes suivantes :
- la préparation du support (2) comprenant la formation de la couche de piégeage (3) sur un substrat de base (6), la couche de piégeage (3) présentant une concentration d'hydrogène inférieure à 10^18 at/cm^3;
- l'assemblage du support (2) avec un substrat donneur, par l'intermédiaire d'une couche diélectrique (4) présentant une concentration d'hydrogène inférieure à 10^20 at/cm^3 ou comprenant une barrière prévenant la diffusion de l'hydrogène vers la couche de piégeage (3) ou présentant une faible diffusivité de l'hydrogène;
- l'élimination d'une partie du substrat donneur pour former la couche mince (5) ;
le procédé de fabrication exposant la structure (1) à une température inférieure à une température maximale de 1000°C. L'invention concerne également une structure obtenue à l'issu de ce procédé.

## Description

### DOMAINE DE L'INVENTION

L'invention concerne un procédé de fabrication d'une structure comprenant une couche mince reportée sur un support muni d'une couche de piégeage de charges.

### ARRIERE PLAN TECHNOLOGIQUE DE L'INVENTION

Les dispositifs intégrés sont usuellement élaborés sur des substrats en forme de plaquettes, qui servent principalement de support à leur fabrication. Toutefois, l'accroissement du degré d'intégration et des performances attendues de ces dispositifs entrainent un couplage de plus en plus important entre leurs performances et les caractéristiques du substrat sur lequel ils sont formés. C'est particulièrement le cas des dispositifs radiofréquences (RF), traitant des signaux dont la fréquence est comprise entre environ 3kHz et 300GHz, qui trouvent notamment leur application dans le domaine des télécommunications (téléphonie, Wi-Fi, Bluetooth...) .

A titre d'exemple de couplage dispositif/substrat, les champs électromagnétiques, issus des signaux hautes fréquences se propageant dans les dispositifs, pénètrent dans la profondeur du substrat et interagissent avec les éventuels porteurs de charges électriques qui s'y trouvent. Il s'en suit une consommation inutile d'une partie de l'énergie du signal par perte d'insertion et des influences possibles entre composants par diaphonie (« crosstalk » selon la terminologie anglo-saxonne).

Les dispositifs radiofréquences, tels que des filtres, des commutateurs et adaptateurs d'antennes ainsi que des amplificateurs de puissance, peuvent être élaborés sur des substrats spécifiquement adaptés pour prendre en compte ces phénomènes et pour en améliorer les performances.

On connaît ainsi les substrats de silicium sur isolant hautement résistif (HR SOI, pour « High Resistivity Silicon On Insulator » selon la terminologie anglo-saxonne habituellement employée) comprenant un substrat support en silicium présentant une résistivité supérieure à 1 kOhm.cm, une couche diélectrique sur le substrat support, et une couche mince superficielle de silicium disposée sur la couche isolante. Le substrat peut également comporter une couche de piégeage de charges disposée entre le substrat support et la couche diélectrique. La couche de piégeage peut comprendre du silicium polycristallin non dopé. La fabrication de ce type de substrat est par exemple décrite dans les documents FR2860341, FR2933233, FR2953640, US2015115480, US7268060 ou US6544656. On cherche généralement à limiter la température et/ou la durée d'un traitement thermique à laquelle est exposé un tel substrat afin d'éviter la recristallisation de la couche de piégeage, ce qui conduirait à détériorer ses performances radiofréquences.

Il existe d'autres raisons pour lesquelles certaines structures semi conductrices ne peuvent pas être exposées au cours de leur fabrication ou de leur utilisation à des températures élevées, par exemple supérieures à 600°C ou à 1000°C. C'est le cas des structures formées de l'assemblage de deux substrats présentant des coefficients de dilatation thermique différents. L'un des substrats forme le support de la structure sur laquelle on reporte une couche mince prélevée de l'autre substrat.

La nature de la couche mince, par exemple lorsqu'elle est constituée d'un matériau ferroélectrique peut également limiter la température de traitement de la structure à sa température de Curie, c'est-à-dire la température au-delà de laquelle le matériau perd sa polarisation permanente.

Par ailleurs, on est parfois incité à limiter la température d'exposition d'une structure semi conductrice lorsque la couche mince comporte des composants. Ces composants peuvent avoir été formés directement sur (ou dans) la structure ou reportés sur un support pour former cette structure. Au-delà d'une exposition de 400°C ou de 600°C, la diffusion des dopants ou des métaux constituant les composants risque de les rendre non fonctionnels.

On peut également choisir de limiter intentionnellement la température à laquelle sont exposés des éléments de la structure. C'est notamment le cas lorsque la couche de piégeage de charges ou la couche diélectrique sont formées par des techniques LPCVD (acronyme de l'expression anglo-saxonne « Low Pressure Chemical Vapor Déposition » ou dépôt chimique en phase vapeur à pression sous atmosphérique) ou PECVD (acronyme de l'expression anglo-saxonne « Plasma Enhanced Chemical Vapor Déposition » ou dépôt chimique en phase vapeur assisté par plasma). Ces techniques peu coûteuses sont collectivement applicables à une pluralité de substrats et sont réalisées à des températures modérées de l'ordre de 600 degrés.

La demanderesse a toutefois observé que la réalisation d'une structure comportant une couche de piégeage de charges électriques et une couche diélectrique à l'aide d'un procédé de fabrication mettant uniquement en œuvre des traitements thermiques modérés (c'est-à-dire n'exposant pas la structure à des températures supérieures à 1000°C) conduisait à des structures dont les performances radiofréquences (RF) étaient bien moins élevées qu'attendues.

Comme cela est documenté dans la publication « White paper - RF SOI Characterisation » de janvier 2015 et publié par la société SOITEC, la performance RF d'un substrat peut être caractérisée par une mesure de distorsion de seconde harmonique HD2. Dans le cas des structures semi conductrices comportant une couche de piégeage de charge et mettant en œuvre uniquement des traitements thermiques modérés, la demanderesse a observé que cette caractéristique HD2 pouvait être comprise entre 55% et 75 % de la valeur attendue.

### OBJET DE L'INVENTION

La présente invention vise à traiter, au moins en partie, ce problème. Elle vise plus particulièrement à proposer un procédé de fabrication d'une structure semi conductrice comprenant le report d'une couche mince sur un support muni d'une couche de piégeage de charges électriques, le procédé n'employant pas de traitement thermique exposant la structure à une température élevée, mais qui résulte néanmoins en une structure présentant des performances RF conforme.

### BREVE DESCRIPTION DE L'INVENTION

En vue de la réalisation de ce but, l'objet de l'invention propose un procédé de fabrication d'une structure comprenant une couche mince reportée sur un support muni d'une couche de piégeage de charges, le procédé comprenant les étapes suivantes :
- la préparation du support comprenant la formation de la couche de piégeage sur un substrat de base, la couche de piégeage présentant une concentration d'hydrogène inférieure à 10^18 at/cm^3 ;
- l'assemblage du support avec un substrat donneur, par l'intermédiaire d'une couche diélectrique présentant une concentration d'hydrogène inférieure à 10^20 at/cm^3 ou comprenant une barrière prévenant la diffusion de l'hydrogène vers la couche de piégeage ou présentant une faible diffusivité de l'hydrogène ;
- l'élimination d'une partie du substrat donneur pour former la couche mince ;
le procédé de fabrication exposant la structure (1) à une température inférieure à une température maximale de 1000°C.

En formant, au cours de l'étape de préparation du support, une couche de piégeage présentant une concentration faible en hydrogène on évite de neutraliser à l'excès les pièges de charges électriques de cette couche. En formant une couche diélectrique présentant également une faible concentration en hydrogène ou prévenant la diffusion de cet hydrogène, on évite ou on limite sa diffusion vers la couche de piégeage, notamment au cours de traitements thermiques auxquels est exposée cette couche diélectrique au cours du procédé de fabrication et après l'étape d'assemblage. Alternativement, on peut prévoir dans la couche diélectrique une barrière prévenant la diffusion de l'hydrogène de la couche diélectrique vers la couche de piégeage.

Selon d'autres caractéristiques avantageuses et non limitatives de l'invention, prises seules ou selon toute combinaison techniquement réalisable :
- la couche de piégeage est déposée à une température de dépôt comprise entre 600°C et 950°C, et l'étape de préparation du support comprend un premier recuit de la couche de piégeage dans une atmosphère pauvre en hydrogène et à une température comprise entre la température de dépôt et 1000°C ;
- le dépôt de la couche de piégeage met en œuvre une technique LPCVD ;
- la couche de piégeage est formée par dépôt à une température comprise entre à 950°C et 1100°C ;
- le dépôt de la couche de piégeage est mis en œuvre dans un bâti d'épitaxie ;
- la couche diélectrique est réalisée par dépôt d'un matériau présentant une concentration en hydrogène supérieure à 10^20 at/cm^3 et suivi de l'application d'un deuxième recuit dans une atmosphère pauvre en hydrogène ;
- le deuxième recuit est compris entre 800°C et 900°C pendant au moins une heure dans une atmosphère neutre ;
- la couche diélectrique est réalisée par dépôt sur la couche de piégeage d'un matériau présentant une concentration en hydrogène supérieure à 10^20 at/cm^3 avant l'application du premier recuit ;
- la couche diélectrique est réalisée par oxydation thermique de la couche de piégeage à une température comprise entre 800°C et 1000°C ;
- la couche diélectrique comprend la barrière et la barrière est directement en contact avec la couche de piégeage ;
- la barrière est constituée d'une couche de SiN ou d'AlN ;
- la couche diélectrique présentant une faible diffusivité de l'hydrogène comprend un oxyde présentant de l'azote dans un ratio azote/oxygène supérieur ou égale à 0,01 ou 0,05 ;
- la couche diélectrique présentant une faible diffusivité de l'hydrogène comprend un oxyde de silicium présentant de l'azote dans un ratio azote/oxygène compris entre 0,01 et 0,25 ou entre 0,05 et 0,1;
- le procédé de fabrication comprend, avant l'étape d'assemblage, une étape de formation d'un plan de fragilisation dans le substrat donneur et dans lequel l'étape d'élimination est réalisée par fracture du substrat donneur au niveau du plan de fragilisation ;
- la couche mince est composée d'un matériau piézoélectrique et/ou ferroélectrique ;
- la couche mince est en tantalate de lithium ou en niobate de lithium.

Selon un autre aspect, l'invention propose une structure ne pouvant pas être exposée à des températures élevées, par exemple supérieures à 600°C ou à 1000°C, la structure comprenant :
- un substrat de base ;
- une couche de piégeage disposée sur le substrat de base et présentant une concentration d'hydrogène inférieure à 10^18 at/cm^3 ;
- une couche diélectrique disposée sur la couche de piégeage, la couche diélectrique présentant une concentration en hydrogène inférieure à 10^20 at/cm^3 ou comprenant une barrière prévenant la diffusion de l'hydrogène vers la couche de piégeage ou présentant une faible diffusivité de l'hydrogène ;
- une couche mince disposée sur la couche diélectrique.

Selon d'autres caractéristiques avantageuses et non limitatives de cet aspect de l'invention, prises seules ou selon toute combinaison techniquement réalisable :
- la couche mince est constituée d'un matériau ferroélectrique présentant une polarisation permanente et une température de Curie comprise entre 600°C et 1000°C ;
- la couche diélectrique est en contact avec la couche de piégeage et avec la couche mince ;
- la couche diélectrique présentant une faible diffusivité de l'hydrogène comprend un oxyde présente de l'azote dans un ratio azote/oxygène supérieur ou égale à 0,01 ou 0,05 ;
- la couche diélectrique présentant une faible diffusivité comprend un oxyde de silicium présente de l'azote dans un ratio azote/oxygène compris entre 0,01 et 0,25 ou entre 0,05 et 0,1.

### BREVE DESCRIPTION DES FIGURES

D'autres caractéristiques et avantages de l'invention ressortiront de la description détaillée de l'invention qui va suivre en référence aux figures annexées sur lesquels :

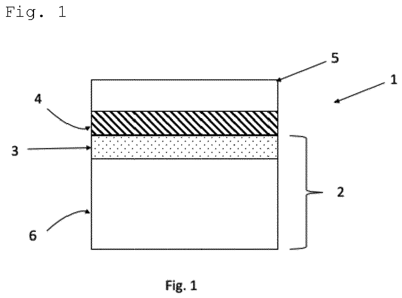

[Fig. 1] La figure 1 représente une structure dont le procédé de fabrication fait l'objet de la présente description ;

### DESCRIPTION DETAILLEE DE L'INVENTION

La figure 1 représente une structure 1 dont le procédé de fabrication fait l'objet de la présente description. La structure 1 présente une couche mince superficielle 5, une couche diélectrique 4, par exemple comprenant un oxyde tel qu'un oxyde de silicium, et un support 2. Le support 2 est muni d'une couche de piégeage de charges 3 disposé sur un substrat de base 6. La couche de piégeage 3 est intercalée entre la couche diélectrique 4 et le substrat de base 6. Préférentiellement, la couche diélectrique 4 est en contact avec la couche de piégeage 3 et avec la couche mince 5.

De manière conventionnelle, la structure 1 peut se présenter sous la forme d'une plaquette circulaire dont le diamètre peut être de 100, 200, 300 voire même 450mm.

Ainsi que cela est présenté dans les documents formant l'état de la technique présenté en préambule, la structure 1 peut être réalisée de multiples manières. Très généralement, la structure 1 peut être réalisée par un procédé de fabrication comprenant l'assemblage du support 2 et d'un substrat donneur, la couche diélectrique étant intercalée entre ces deux éléments, suivi d'une étape d'élimination d'une partie du substrat donneur pour former la couche mince 5. L'étape d'élimination d'une partie du substrat donneur peut être réalisée par amincissement mécano-chimique de ce substrat. Préférentiellement, la structure 1 est fabriquée par application de la technologie Smart Cut^{™}, selon laquelle une couche destinée à former la couche mince 5 est délimitée par l'intermédiaire d'un plan de fragilisation formé par implantation d'espèces légères dans le substrat donneur. Cette couche est ensuite prélevée du substrat donneur par fracture au niveau du plan de fragilisation et reportée sur le support 2 muni de la couche de piégeage 3 par l'intermédiaire de la couche diélectrique 4, intercalée entre le support 2 et le substrat donneur.

Le substrat de base 6 présente typiquement une épaisseur de plusieurs centaines de microns. Préférentiellement, le substrat de base présente une résistivité élevée, supérieure à 1000 ohm.centimètre, et plus préférentiellement encore, supérieure à 2000 ohm.centimètre. On limite de la sorte la densité des charges, trous ou électrons, qui sont susceptibles de se déplacer dans le substrat de base. Mais l'invention n'est pas limitée à un substrat de base 6 présentant une telle résistivité, et elle procure également des avantages de performance RF lorsque le substrat de base présente une résistivité plus conforme, de l'ordre de quelques centaines d'ohm.centimètres, par exemple inférieure à 1000 ohm.cm, ou à 500 ohm.cm voire même à 10 ohm.cm.

Pour des raisons de disponibilité et de coût, le substrat de base 3 est préférentiellement en silicium monocristallin. Il peut s'agir par exemple d'un substrat de silicium CZ à faible teneur en oxygène interstitiel comprise entre 6 et 10 ppm, ou d'un substrat de silicium FZ qui présente notamment une teneur en oxygène interstitiel naturellement très faible. Il peut également s'agir d'un substrat de silicium CZ présentant une quantité élevée d'oxygène interstitiel (désigné par l'expression « High Oi ») supérieure à 26 ppm. Le substrat de base peut alternativement être formé d'un autre matériau : il peut s'agir par exemple de saphir, de verre, de quartz, de carbure de silicium... Dans certaines circonstances, et notamment lorsque la couche de piégeage 3 présente une épaisseur suffisante, par exemple supérieure à 30 microns, le substrat de base 6 peut présenter une résistivité standard, inférieure à 1 kohm.cm.

La couche de piégeage 3 peut être de nature très variée, ainsi que cela est reporté dans les documents formant l'état de la technique. D'une manière générale, il s'agit d'une couche non cristalline présentant des défauts structurels tels que des dislocations, des joints de grains, des zones amorphes, des interstices, des inclusions, des pores... Ces défauts structurels forment des pièges pour les charges susceptibles de circuler dans le matériau, par exemple au niveau de liaisons chimiques non complètes ou pendantes. On prévient ainsi la conduction dans la couche de piégeage qui présente en conséquence une résistivité élevée.

De manière avantageuse, et pour des raisons de simplicité de mise en œuvre, cette couche de piégeage 3 est formée d'une couche de silicium polycristallin. Son épaisseur, notamment lorsqu'elle est formée sur un substrat de base 6 résistif, peut être comprise entre 0,3 à 3 µm. Mais d'autres épaisseurs inférieures ou supérieures à cet intervalle sont tout à fait envisageables, selon le niveau de performance RF attendu de la structure 1.

Afin de chercher à préserver la qualité polycristalline de cette couche au cours des traitements thermiques que peut subir la structure 1, on peut avantageusement prévoir une couche amorphe, en dioxyde de silicium par exemple, sur le substrat de base 6 avant le dépôt de la couche de piégeage de charges 3.

On peut alternativement former la couche de piégeage 3 par une implantation d'espèce relativement lourde, tel que de l'argon, dans une épaisseur superficielle du substrat de base 6, afin d'y former les défauts structurels constituant les pièges électriques. On peut également former cette couche 3 par porosification d'une épaisseur superficielle du substrat de base 6 ou par toute autre méthode apte à former des défauts structurels dans une épaisseur superficielle du substrat de base 6, ces défauts structurels étant aptes à piéger des charges électriques.

La couche mince superficielle 5 peut être de toute nature qui convient. Lorsque la structure 1 est destinée à recevoir des composants intégrés à semi-conducteur, la couche mince 5 peut être ainsi composée de silicium monocristallin, ou de tout autre matériau semi-conducteur tel que du germanium, du silicium germanium du carbure de silicium. Lorsque la structure 1 est destinée à recevoir des filtres à onde acoustique de surface, la couche mince 5 peut être composée d'un matériau piézoélectrique et/ou ferroélectrique, tel que du tantalate de lithium ou du niobate de lithium. La couche mince 5 peut également comprendre des composants intégrés finis ou semi-finis, formés sur le substrat donneur et reportés sur le support 2 au cours de l'étape de fabrication de la structure 1. D'une manière générale, la couche mince peut présenter une épaisseur comprise entre 10nm et 10 microns.

On présente maintenant un procédé de fabrication d'une structure conforme à celle représentée sur la figure 1. Ce procédé constitue une expérience préliminaire ayant conduit à la présente invention. Selon ce procédé expérimental, sur un substrat de base 6 en silicium, on a formé par dépôt une couche de piégeage de charges 3 en silicium polycristallin, à l'aide d'une technique LPCVD conduite entre 600°C et 650°C. La couche piégeage 3 présentait une épaisseur d'environ 1 micron.

Sur la couche de piégeage 3 on a déposé, par une technique PECVD conduite à une température de 600°C, une couche d'oxyde de silicium de 300nm à 1000nm d'épaisseur formant la couche diélectrique 4 de la structure 1. Ce dépôt a été suivi d'un recuit de densification mené à 600°C dans une atmosphère neutre ou oxydante pendant environ 1h. La couche a ensuite été polie par une étape de polissage mécano-chimique (CMP) conduisant à un enlèvement d'environ 200 à 800 nanomètres de l'oxyde pour fournir une surface présentant une rugosité inférieure à 0,3 nm RMS sur un champ de 5*5 microns.

Un substrat donneur ferroélectrique de tantalate de lithium a été implanté par des ions d'hydrogène à travers une première de ses faces afin de former un plan de fragilisation enterré. On a défini de la sorte une première couche entre ce plan de fragilisation est la première face du substrat donneur. On a assemblé le substrat donneur à la couche d'oxyde de silicium 4 disposée sur le support 2 et on a fracturé ensuite le substrat donneur au niveau du plan de fragilisation à l'aide d'un traitement thermique modéré de l'ordre de 400°C. On a libéré la première couche du substrat donneur pour exposer une face libre de cette couche qui a ainsi pu être préparée pour en améliorer la qualité cristalline et l'état de surface. Cette préparation a compris une étape d'amincissement de la première couche par polissage mécano-chimique et une étape de traitement thermique à 500°C dans une atmosphère neutre pendant 1h.

On a estimé le niveau de performance RF attendu de la structure ainsi réalisée par une détermination de la valeur de HQF (Harmonies Quality Factor) tel que cela est enseigné dans le document US2015/0168326. Cette valeur HQF peut être estimée à partir du profil de résistivité en profondeur de la couche de piégeage 4 et du substrat de base 6.

On a ensuite réalisé une mesure de caractérisation dite « de distorsion de seconde harmonique » (HD2) sur la structure 1 ainsi préparée. Cette mesure est réalisée à 900MHz et elle est documentée dans le document « White paper - RF SOI wafer characterisation » présenté en introduction. Plus précisément, on a formé des guides coplanaires en déposant des lignes d'aluminium sur la face libre de la couche mince superficielle de tantalate de lithium. Puis un signal présentant une fréquence de 900 MHz est appliqué à une extrémité des guides et le signal de seconde harmonique HD2 est mesuré à l'autre extrémité. Plus le signal de seconde harmonique est faible, plus le niveau de performance de la structure est élevé.

La mesure HD2 et l'estimation HQF sont des caractéristiques particulièrement pertinentes de la structure 1 car très représentatives de la performance d'un dispositif intégré RF qui serait formé sur cette structure.

De manière inattendue, la valeur de la caractéristique HD2 de la structure 1 à l'issue du procédé qui vient d'être décrit ne correspondait qu'à environ 50% à 75% de l'attendu fourni par l'estimation HQF.

Des études complémentaires ont permis à la demanderesse de réaliser que ce faible niveau de performance était lié à la présence en excès d'hydrogène dans la couche de piégeage de charge 3 et dans la couche diélectrique 4. La couche diélectrique, ici de SiO2, présentait plus de 10^20 at/cm^3 et la couche de piégeage 3 plus de 10^18 at/cm^3 d'hydrogène.

La couche diélectrique 4 particulièrement riche en hydrogène forme en quelque sorte un réservoir, et l'hydrogène retenu dans cette couche 4 est susceptible de diffuser vers la couche de piégeage 3 lorsque l'écart de concentration en hydrogène dans la couche diélectrique 4 et la couche de piégeage 3 est excessif, et compte tenu des traitements thermiques appliqués à la structure 1. En conséquence, la couche de piégeage est alimentée en hydrogène par la couche diélectrique 4. L'hydrogène est alors susceptible de neutraliser les pièges électriques de la couche de piégeage 3, notamment au niveau de son interface avec la couche diélectrique 4. On note que dans une structure conventionnelle exposée à une température excédant les 1000°C, par exemple dans une étape finale de finition de la structure, l'hydrogène contenu dans la couche diélectrique 4 ou dans la couche de piégeage 3 est éliminée par diffusion au cours du traitement thermique, et qu'un tel écart entre la mesure HD2 et l'estimation HQF ne se produit donc pas de manière aussi notable.

La demanderesse a mis alors à profit la découverte de ces mécanismes pour mettre au point un procédé de fabrication n'employant pas de traitement thermique exposant la structure à une température élevée, mais qui résulte néanmoins en une structure présentant des performances RF conforme. Par conforme, on signifie que la mesure HD2 ne s'écarte pas de plus de 20% de son estimation HQF.

D'une manière générale, ce procédé vise à former une couche de piégeage 3 présentant une concentration relativement faible en hydrogène afin d'éviter de neutraliser à l'excès les pièges de charges électriques. On vise également à former une couche diélectrique 4 présentant une faible concentration d'hydrogène ou limitant la diffusion de cet hydrogène afin d'éviter ou de limiter la migration de cet hydrogène dans la couche de piégeage compte tenu des traitements thermiques appliqués à la structure.

Plus précisément, ce procédé reprend les étapes de préparation du support 2, d'assemblage de ce support 2 avec un substrat donneur et d'élimination d'une partie du substrat donneur qui viennent d'être décrites. Pour toutes les raisons invoquées en introduction de cette demande, la structure 1 ne peut être exposée à une température excédant 1000°C au cours de sa fabrication pendant l'étape d'assemblage ou à la suite de cette étape. Toutefois, dans ce procédé, on cherche à former au cours de l'étape de préparation du support une couche de piégeage 3 présentant une concentration faible en hydrogène, moindre que 10^18 at/cm^3, pour éviter de neutraliser à l'excès les pièges de cette couche 3. Dans le même temps, on cherche à former une couche diélectrique 4 présentant également une faible concentration en hydrogène, moindre que 10^20 at/cm^3, ou limitant la diffusion de cet hydrogène pour éviter de constituer un réservoir d'hydrogène qui serait alors susceptible de diffuser vers la couche de piégeage 3 ou au niveau de l'interface avec cette couche. Alternativement, on peut prévoir dans la couche diélectrique une barrière prévenant la diffusion de l'hydrogène vers la couche de piégeage. Avantageusement, lorsque la couche diélectrique ne présente pas de couche barrière ou qu'elle n'est pas susceptible de piéger l'hydrogène qu'elle contient, on cherchera à limiter la concentration en hydrogène dans la couche diélectrique à moins de 10^19 at/cm^3, voire même à moins de 10^18 at/cm^3.

Plusieurs modes de mise en œuvre sont envisageables pour réaliser de telles couches de piégeage 3 et diélectrique 4.

Ainsi, et selon un premier mode de réalisation de la couche de piégeage 3, celle-ci peut être formée par dépôt à une température modérée, par exemple strictement comprise entre 600°C et 950°C. Il peut s'agir d'un dépôt d'une couche de silicium polycristallin formé par une technique LPCVD mise en œuvre dans un four de dépôt. Un tel dépôt, on l'a vu, conduit à former une couche de piégeage 3 comprenant une concentration en hydrogène supérieure à 10^18 at/cm^3 et typiquement comprise entre cette valeur et 10^19 at/cm^3.

Pour réduire cette concentration, on prévoit selon ce premier mode de réalisation, un premier recuit de la couche de piégeage dans une atmosphère pauvre en hydrogène (i.e inférieur à 5 ppm) à une température comprise entre la température de dépôt et 1000°C. Avantageusement la température du premier recuit est supérieure à 620°C et préférentiellement inférieure à 900°C, pendant au moins une heure et préférentiellement pendant quelques heures. On exodiffuse efficacement dans ces conditions préférentielles de recuit l'hydrogène présent dans la couche de piégeage 3 pour réduire sa concentration sous le seuil de 10^18 at/cm^3, sans détériorer la nature polycristalline de la couche de piégeage, par effet de recristallisation.

Le premier recuit peut être réalisé directement après le dépôt de la couche de piégeage 3, ou après la formation de la couche diélectrique 4 lorsque celle-ci est déposée au moins en partie sur la couche de piégeage 3 comme cela sera précisé dans la suite de cet exposé.

Selon un deuxième mode de réalisation de la couche de piégeage 3, celle-ci est déposée à haute température sur le substrat de base 6, par exemple à une température comprise entre 950°C et 1100°C. Il peut s'agir d'un dépôt de silicium polycristallin réalisé dans un réacteur d'épitaxie. Dans de telles conditions de dépôt, la couche de piégeage 3 présente une concentration en hydrogène plusieurs fois inférieure à celle d'une couche formée par une technique LPCVD. Dans tous les cas, on veillera à ce que cette concentration soit inférieure à 10^18 at/cm^3. Dans ce deuxième mode de réalisation dans lequel on forme directement la couche de piégeage 3 pour qu'elle présente une concentration faible en hydrogène, le premier recuit qui était prévu dans le mode précédent pour exodiffuser l'hydrogène n'est pas nécessaire.

La couche diélectrique 4 peut-être formée quant à elle par dépôt sur la couche de piégeage 3. Alternativement, ou en complément, elle peut être formée en totalité ou en partie par dépôt sur la première face du substrat donneur. On pourra choisir de former la couche diélectrique 4 sur le support ou sur le substrat donneur selon qu'il est possible ou non de les exposer à une température relativement élevée.

Ainsi, et selon un premier mode de réalisation de la couche diélectrique 4, celle-ci est réalisée par un dépôt d'oxyde de silicium par une technique PECVD dans un four de dépôt. Ce dépôt est réalisé à une température modérée, typiquement comprise entre 600°C et 800°C. Dans ce cas, la couche diélectrique 4 présente une concentration en hydrogène importante de plus de 10^20 at/cm^3.

Pour réduire cette concentration, on prévoit d'appliquer un deuxième recuit, dit « de densification », similaire au premier recuit décrit précédemment. Il s'agit donc d'un recuit sous atmosphère pauvre en hydrogène (i.e. inférieure à 5 ppm) et exposant la couche 4 à une température supérieure à sa température de dépôt. Il peut s'agir d'une atmosphère neutre ou oxydante. Préférentiellement cette température est supérieure à 800°C, typiquement comprise entre 800°C et 900°C. Le recuit est poursuivi pendant au moins une heure, et préférentiellement pendant plusieurs heures, enfin d'exodiffuser l'hydrogène de la couche diélectrique 4, et éventuellement de la couche de piégeage 3. A l'issue de ce recuit de densification, la couche diélectrique 4 présente une concentration d'hydrogène inférieure 10^20 at/cm^3 et la couche de piégeage 3 présente une concentration d'hydrogène inférieure 10^18 at/cm^3.

On notera que le deuxième recuit de densification peut venir modifier d'autres caractéristiques de la couche diélectrique que sa concentration en hydrogène. Il peut notamment conduire à réduire la diffusivité de l'hydrogène, c'est-à-dire la capacité de cette espèce à diffuser dans le matériau constituant la couche diélectrique, si bien que l'hydrogène même en concentration relativement importante (de l'ordre de 10^20 at/cm^3) est moins susceptible de diffuser vers la couche de piégeage 3.

On préférera généralement disposer la couche diélectrique 4 sur le support 2 plutôt que sur le substrat donneur. En effet, il est généralement possible de traiter thermiquement ce support 2 à la température du premier et/ou deuxième recuit, ce qui n'est pas toujours le cas du substrat donneur. Par exemple, ce substrat peut présenter un plan de fragilisation, ou être composé d'un matériau ferroélectrique présentant une température de Curie relativement faible ou comporter des composants, ce qui, dans chacun de ces cas, limite le budget thermique qui lui est applicable à quelques centaines de degrés pendant un temps relativement court, inférieur à 1 heure. Toutefois, l'invention n'exclut pas que, dans certains cas favorables, la couche diélectrique 4 puisse être formée au moins en partie sur le substrat donneur.

Lorsque la couche diélectrique 4 est formée sur la couche de piégeage 3, et que ces deux couches ont été déposées à relativement basse température comme cela vient d'être exposé, il n'est pas nécessaire d'appliquer respectivement le premier et le deuxième recuit après chaque étape de dépôt. Comme on l'a déjà brièvement évoqué, il est possible de réaliser un unique recuit, dans des conditions similaires au premier et au deuxième recuit, après la formation de la couche diélectrique 4 à basse température sur la couche de piégeage 3. En d'autres termes, il n'est pas nécessaire dans ce cas d'appliquer un recuit spécifique de la couche de piégeage 3 avant le dépôt de la couche diélectrique 4.

Selon un deuxième mode de réalisation de la couche diélectrique 4, celle-ci peut être réalisée par oxydation thermique de la couche de piégeage 3. Un tel traitement peut être mis en œuvre en exposant le support 2 muni de la couche de piégeage 3 dans un four d'oxydation à une température strictement comprise entre 800°C et 1000°C et dans une atmosphère riche en oxygène. Il peut s'agir d'une atmosphère sèche ou humide. Comme cela est bien connu en soi, la durée de cette exposition est choisie selon l'épaisseur désirée de la couche diélectrique 4. On préférera généralement limiter la température d'oxydation à 1000°C pour éviter tout risque de recristallisation de la couche de piégeage 3. On préférera d'ailleurs réaliser une telle couche diélectrique 3 par oxydation d'une couche de piégeage 3 formée à haute température conformément au deuxième mode de réalisation de cette couche qui a été exposé précédemment. En effet, une telle couche présente une plus grande stabilité en température vis-à-vis du risque de recristallisation.

Une couche diélectrique 4 formée par oxydation thermique de la couche de piégeage, en dioxyde de silicium lorsque la couche de piégeage 3 est en silicium (ce qui est souvent le cas), présente une concentration d'hydrogène particulièrement faible, de l'ordre de quelques 10^17 at/cm^3, à la limite de détection des méthodes de mesures usuelles. On pourra introduire éventuellement une étape de polissage de la surface ainsi oxydée de la couche de piégeage 3 afin de la rendre compatible avec l'étape ultérieur d'assemblage.

La couche diélectrique 4 peut également être préparée selon un troisième mode de mise en œuvre qui trouve un intérêt particulier lorsqu'il n'est pas possible d'exposer la couche diélectrique 4 à une température relativement élevée, par exemple supérieure à 800°C. Dans ce cas, on peut former la couche diélectrique 4 à relativement basse température, par exemple conformément au premier mode de réalisation de cette couche, et on prend soin d'inclure dans la couche diélectrique 4 une barrière prévenant la diffusion de l'hydrogène dans la couche de piégeage.

Ainsi, et bien que la couche diélectrique 4 puisse présenter une concentration en hydrogène supérieure à 10^20 at/cm^3, on prévient la diffusion de l'hydrogène contenu dans la couche diélectrique 4 vers la couche de piégeage 3 qui présente elle-même une concentration moindre que 10^18 at/cm^3. Et on évite ainsi de neutraliser les pièges de charge électrique de cette couche 3. Dans une variante, la couche diélectrique 4 est entièrement constituée de la barrière, celle-ci retenant en son sein l'hydrogène qu'elle pourrait contenir.

La barrière peut consister en ou comprendre une couche de nitrure de silicium ou de nitrure d'aluminium d'épaisseur supérieure à 10 nanomètres et typiquement comprise entre 10 et 100 nanomètres. La barrière peut être déposée directement sur la couche de piégeage 3, par exemple par une technique PECVD, avant la formation du reste de la couche diélectrique 4, par exemple en dioxyde de silicium et riche en hydrogène. Alternativement cette barrière peut être formée sur le substrat donneur, et dans ce cas après la formation du reste de la couche diélectrique 4 de sorte que la barrière puisse être mise en contact avec la couche de piégeage 3 lors de l'étape suivante d'assemblage du donneur et du support 2.

Dans une autre variante la couche barrière est formée d'une couche d'oxyde de silicium présentant une concentration en hydrogène très faible, de l'ordre de 10^17 at/cm^3. Dans ce cas, la barrière forme un tampon qui absorbe l'hydrogène de la couche diélectrique et prévient donc sa diffusion vers la couche de piégeage 3. On prévoira dans ce cas une épaisseur suffisante de la couche barrière tenant compte de l'épaisseur de la couche diélectrique et de sa concentration en hydrogène, pour qu'après diffusion de cet hydrogène dans la couche barrière, sa concentration en hydrogène n'excède pas 10^20 at/cm^3. Cette variante peut être mise en œuvre lorsque la couche diélectrique est formée par dépôt du côté du substrat donneur, et la couche barrière formée par oxydation thermique de la couche de piégeage 3 , comme cela a été décrit en relation avec le deuxième mode de réalisation de cette couche diélectrique 4.

Selon une autre approche encore, on peut prévoir que la couche diélectrique 4 présente une concentration en hydrogène quelconque, mais que cette couche 4 présente une faible diffusivité de cet hydrogène, qui y reste donc suffisamment piégé pour ne pas diffuser de manière notable vers la couche de piégeage 3. Dans ce cas la couche diélectrique 4 peut être entièrement constituée d'une couche formée d'un matériau qui prévient la diffusion de l'hydrogène qu'elle contient. Il peut ainsi s'agir d'un oxyde déposé, par exemple un oxyde de silicium SiON, présentant de l'azote dans un ratio azote/oxygène supérieur ou égale à 0,01 ou avantageusement supérieure ou égale à 0,05. Lorsque la couche diélectrique 4 est à base d'oxyde de silicium, ce qui est très usuel, on pourra choisir de ne pas excéder un ratio azote/oxygène n'excédant pas 0,1 ou 0,25 pour ne pas modifier excessivement les caractéristiques de ce matériau et conserver un comportement équivalent ou proche de celui d'un simple oxyde de silicium SiO2. On note qu'une telle couche d'oxyde riche en azote peut facilement être constituée par une technique, par exemple PECVD, dont un des gaz porteurs au moins peut être choisi pour être de l'azote qui peut s'incorporer de manière maitrisée dans la couche d'oxyde. Le ratio azote/oxyde peut être mesuré par une technique dite EDX (pour « energy-dispersive X-ray spectroscopy » ou « spectroscopie aux rayons X à dispersion d'énergie » en français) ou élaboré a partir des mesures d'azote et d'oxygène déterminés par mesures SIMS (spectrométrie de masse à ions secondaires) dans la couche d'oxyde 4.

D'une manière générale, on dira d'une couche diélectrique 4 qu'elle présente une faible diffusivité de l'hydrogène qu'elle contient, lorsqu'une structure comprenant :
- couche diélectrique contenant une concentration d'au moins 10^20 at/cm^3 d'hydrogène, et disposée en contact avec cette couche,
- une couche de piégeage de 1 micron de silicium polycristallin présentant initialement une concentration contenant une concentration inférieure à 10^18 at/cm^3 d'hydrogène,
est soumise à un recuit de 500°C pendant 1h, conduit à mesurer dans la couche de piégeage, à l'issue du traitement thermique, une concentration d'hydrogène inférieure à 10^18 at/cm^3.

La couche diélectrique 4 peut consister sur toute son épaisseur d'un matériau présentant une faible diffusivité, par exemple un oxyde déposé comprenant de l'azote dans les proportions mentionnées ci-dessus. Alternativement, on peut prévoir que seule une couche barrière prévenant la diffusion d'hydrogène vers la couche de piégeage 3 soit constituée de ce matériau présentant une faible diffusivité, dans la configuration présentée dans l'alternative précédente.

L'étape d'assemblage peut être précédée du polissage de certaines au moins des faces mises en contact, notamment celles correspondant aux faces exposées des couches déposées de piégeage et/ou diélectrique. Et comme on l'a vu, cette étape d'assemblage est suivie de l'élimination d'une partie du substrat donneur pour former la couche mince 5. Cette élimination peut être réalisée par un amincissement du substrat donneur ou par sa fracture. On peut prévoir une étape de préparation de la couche reportée, par exemple un polissage et/ou un recuit thermique, afin d'améliorer les caractéristiques de la couche mince 5.

Les étapes d'assemblage, d'élimination d'une partie du substrat donneur et de préparation de la couche reportée sont réalisées à des températures modérées, exposant la structure 1 à des températures toujours inférieures à 1000°C, et préférentiellement inférieures à 800°C ou 600°C. D'une manière plus générale, on cherche à limiter l'exposition en température de la couche diélectrique 4 au moins pendant et après l'étape d'assemblage lors du procédé de fabrication pour limiter de la sorte la diffusion de l'hydrogène de cette couche vers la couche de piégeage 3. En règle générale, plus la concentration dans la couche diélectrique est importante (tout en restant sous le seuil de 10^20 at/cm^3), plus on limitera la température maximale à laquelle la couche diélectrique 4 et la structure 1 sont soumises.

Quelle que soit les modes de réalisation choisis de la couche de piégeage 3 et de la couche diélectrique 4, on dispose à l'issue du procédé de fabrication qui vient d'être décrit d'une structure 1, telle que celle représentée sur la figure 1, comprenant:
- un substrat de base 6;
- une couche de piégeage 3 disposée sur le substrat de base 6 et présentant une concentration d'hydrogène inférieure à 10^18 at/cm^3 ;
- une couche diélectrique 4 disposée sur la couche de piégeage 3, et avantageusement en contact avec cette couche. La couche diélectrique 4 présente une concentration en hydrogène inférieure à 10^20 at/cm^3 ou comprend une barrière prévenant la diffusion de l'hydrogène vers la couche de piégeage 3 ou présente une concentration en hydrogène quelconque, mais présente alors une très faible diffusivité de l'hydrogène.
- une couche mince 5 disposée sur la couche diélectrique 4 et préférentiellement en contact avec cette couche. Cette couche mince 5 peut-être constituée d'un matériau semi-conducteur tel que du silicium, d'un isolant tel qu'un matériau ferroélectrique ou d'une couche comprenant des composants semi-conducteurs intégrés.

Avantageusement, la concentration en hydrogène dans la couche diélectrique est inférieure à 10^19 at/cm^3, voire même à 10^18 at/cm^3.

La couche diélectrique peut comprendre un oxyde présentant de l'azote dans un ratio azote/ oxygène supérieur ou égale à 0,01 ou 0,05. Dans ce cas, sa concentration en hydrogène peut être quelconque. Elle peut être constituée ou comprendre un oxyde de silicium présentant de l'azote dans un ratio azote/oxygène compris entre 0,01 et 0,25 ou entre 0,05 et 0,1.

Lorsque la couche mince est constituée d'un matériau ferroélectrique présentant une température de Curie inférieure à 1000°C, et typiquement comprise entre 600°C et 1000°C, il est possible de fabriquer la structure sans excéder exposer cette couche mince à une température supérieure à cette température de Curie et donc de préserver sa polarisation permanente.

À titre d'exemple, on a réalisé une pluralité de supports 2 comprenant un substrat de base 6 en silicium présentant une résistivité de 3000 ohm.cm et sur lequel on a successivement réalisé une couche de piégeage 3 en silicium polycristallin présentant une épaisseur de 1 micron et formée par LPCVD, et une couche diélectrique en oxyde de silicium de 300 nanomètres d'épaisseur réalisée par une technique de PECVD.

On a appliqué à un premier lot de supports ainsi réalisés, un recuit de densification de l'empilement à une température de 600°C pendant une heure dans une atmosphère riche en oxygène et présentant moins de 5 ppm d'hydrogène.

Un deuxième et un troisième lot ont été exposés à un recuit de densification conforme à la présente invention, riche en oxygène et présentant moins de 5 ppm d'hydrogène, pendant au moins une heure et à une température respective de 800°C et 900°C.

A l'issue du recuit de densification, on a mesuré la concentration en hydrogène dans la couche de piégeage (« H piégeage - post densif ») et dans la couche diélectrique (« H diélectrique »)

Sur les supports 2 de chacun de ces lots, on a reporté une couche mince superficielle 5 de tantalate de lithium à l'aide du procédé Smart Cut. On a préparé cette couche pour qu'elle présente au final une épaisseur de 600nm. Les étapes de fabrication des structures prévoyaient des recuits modérés qui n'ont pas excédé 600°C. Sur les trois lots de structures ainsi préparés, on a procédé à des mesures de concentration en hydrogène de la couche de piégeage 3 (« H piégeage - structure »), à des mesures de seconde harmonique (« HD2 » - pour un signal appliqué de 15dBm) et à des mesures du profil de résistivité des supports 2 pour déterminer des facteurs de qualité (« HQF »). On rappelle que cette valeur HQF permet d'estimer la valeur attendue, conforme, de la performance RF d'une structure.

Les résultats moyens sur chacun des premier, deuxième et troisième lots sont présentés dans le tableau ci-dessous :

**[Tableau 1]**

| Lot | HD2 | HQF | HD2/HQF | H piégeage | H Diélectrique |
|---|---|---|---|---|---|
| 1 | -60dBm | -92dBm | 65% | Post densif : 1.5 10^18 at/cm^3 | 10^21 at/cm^3 |
| | | | | Structure : > 4.10^18 at/cm^3 | |
| 2 | -79.4 dBm | -95dBm | 83% | Post densif : 2 10^17 at/cm^3 | 10^20 at/cm^3 |
| | | | | Structure : 10^18 at/cm^3 | |
| 3 | -84.2 dBM | -83dBm | 100% | Post densif : 1.5 10^17 at/cm^3 | 6. 10^19 |
| | | | | Structure : 10^18 at/cm^3 | |

On observe que les performances RF des structures du premier lot, ayant reçu des traitements de l'état de la technique, sont bien en deçà de l'attendu (le ratio HD2/HQF est de 65%). On observe que la concentration en hydrogène dans les différentes couches excède les valeurs limites, notamment la concentration en hydrogène de la couche de piégeage 3 juste après le recuit de densification (« post densif ») ainsi que dans la structure finale (« Structure »).

Au contraire, les performances RF des structures du deuxième lot et du troisième lot, qui ont reçu des traitements conformes à l'invention, sont bien au niveau de l'attendu (ratio HD2/HQF de, respectivement, 83% et 100%).

On observe que la concentration en hydrogène dans la couche de piégeage 3 mesurée après la fabrication complète de la structure est supérieure à la concentration mesurée juste après le recuit de densification. Toutefois, cette concentration reste inférieure ou égale au seuil de 10^18 at/cm^3, ce qui permet de maintenir la performance RF conforme. L'hydrogène présent dans la couche diélectrique n'a pas migré de manière significative vers la couche de piégeage même après avoir été traité thermiquement au cours de la fabrication de la structure 1.

On note que la susceptibilité d'une structure 1 présentant une couche de piégeage 3 sous la couche diélectrique 4 est d'autant plus sensible à l'hydrogène contenue dans cette couche que la couche de piégeage est fine. En effet, pour une même quantité d'hydrogène ayant diffusée de la couche diélectrique 4 vers la couche de piégeage 3, la concentration d'hydrogène dans cette couche de piégeage sera plus importante dans une couche de piégeage relativement fine que dans une couche de piégeage relativement épaisse. Aussi, l'approche de l'invention est particulièrement intéressante lorsque la couche de piégeage présente une épaisseur inférieure à 1 micron, ou 750nm, ou inférieure ou égale à 500nm. Dans une telle configuration d'une couche de piégeage relativement fine, inférieure à 1 micron, on pourra choisir notamment choisir d'intégrer dans la couche de diélectrique 4, au plus près de la couche de piégeage, une couche barrière ou une couche de SiON limitant la diffusion de l'hydrogène, dont l'épaisseur peut être par exemple de 20 à 50nm. Par exemple, une couche d'oxyde de silicium peut être formée sur la couche de piégeage, et cette couche préparée à l'aide d'un plasma à base d'azote pour incorporer cet azote superficiellement avant son assemblage avec une autre portion de la couche diélectrique 4 disposée du côté du substrat donneur. On forme ainsi sur l'épaisseur superficielle de la couche d'oxyde une couche barrière de SiO riche en azote qui prévient la diffusion de l'hydrogène contenue dans le reste de la couche diélectrique 4 vers la couche de piégeage.

On rappelle que la performance RF d'une structure a une influence déterminante sur le facteur de qualité des composants formés sur cette structure. La demanderesse a ainsi vérifié, dans des observations complémentaires, que la conductance à l'anti résonnance de résonateurs formés sur une structure élaborée selon un procédé conforme à l'invention était directement liée à la performance RF de la structure. De tels résonateurs peuvent être constitués de peignes interdigités formés sur des substrats identiques ou similaires à ceux des lots 1 ou 2 exposés ci-dessus. Le facteur de qualité d'un tel résonateur est généralement déterminé comme le rapport entre la résistance électrique à la fréquence d'anti résonnance et la largeur de bande à mi-hauteur de cette résistance. Ce facteur de qualité a été évalué, sur les résonateurs réalisés sur les structures des lots 2 et 3 conformes à l'invention, bien supérieur au facteur de qualité des résonateurs réalisés sur les structures du lot 1.

Bien entendu l'invention n'est pas limitée aux modes de mise en œuvre décrits et on peut y apporter des variantes de réalisation sans sortir du cadre de l'invention tel que défini par les revendications.

En particulier, la couche mince 5 peut comprendre ou être formée d'un matériau ferroélectrique, par exemple de LiTaO3, LiNbO3, LiAlO3, BaTiO3, PbZrTiO3, KNbO3, BaZrO3, CaTiO3, PbTiO3 ou de KTaO3.

Le substrat donneur d'où est prélevée la couche mince 5 peut prendre la forme d'une plaquette, circulaire, de dimension normalisée, par exemple de 150 mm ou 200 mm de diamètre. Mais l'invention n'est nullement limitée à ces dimensions ou à cette forme. Le substrat donneur peut avoir été prélevé d'un lingot de matériaux ferroélectrique, ce prélèvement ayant été réalisé de manière à ce que le substrat donneur présente une orientation cristalline prédéterminée, ou encore le substrat donneur peut comprendre une couche de matériau ferroélectrique assemblé à un substrat support.

L'orientation cristalline de la couche mince de matériau ferroélectrique peut être choisie en fonction de l'application visée. Ainsi, en ce qui concerne le matériau LiTaO3, il est usuel de choisir une orientation comprise entre 30° et 60°XY, ou entre 40° et 50°XY, en particulier dans le cas où l'on souhaite exploiter les propriétés de la couche mince pour former un filtre acoustique de surface (SAW). En ce qui concerne le matériau LiNbO3 il est usuel de choisir une orientation autour de 128° XY. Mais l'invention n'est nullement limitée à une orientation cristalline particulière.

## Revendications

1. Structure (1) comprenant :
- un substrat de base (6);
- une couche de piégeage (3) disposée sur le substrat de base (6) et présentant une concentration d'hydrogène inférieure à 10^18 at/cm^3 ;
- une couche diélectrique (4) disposée sur et en contact avec la couche de piégeage (3), au moins une portion d'épaisseur de la couche diélectrique (4) étant constituée d'oxyde de silicium SiON présentant de l'azote dans un ratio azote/oxygène supérieur ou égale à 0,01, ;
- une couche mince (5) ferroélectrique disposée sur la couche diélectrique (4).

2. Structure (1) selon la revendication précédente dans laquelle la couche diélectrique (4) consiste sur toute son épaisseur d'oxyde de silicium SiON présentant de l'azote dans un ratio azote/oxygène supérieur ou égal à 0,01.

3. Structure (1) selon l'une des revendications précédentes dans laquelle la portion d'épaisseur en oxyde de silicium SiON de la couche diélectrique (4) présente de l'azote dans un ratio azote/oxygène inférieur ou égal à 0,25.

4. Structure (1) selon l'une des revendications précédentes dans laquelle la couche mince (5) ferroélectrique est constituée de LiTaO3 ou de LiNbO3.

5. Structure (1) selon la revendication précédente dans laquelle la couche mince (5) ferroélectrique est constituée de LiTaO3 et présente une orientation comprise entre 30° et 60°XY, ou entre 40° et 50°XY.

6. Structure (1) selon la revendication 4 dans laquelle la couche mince (5) ferroélectrique est constituée de LiNbO3 et présente une orientation sensiblement égale à 128° XY.

7. Structure (1) selon l'une des revendications précédentes dans laquelle le substrat de base (3) est en silicium monocristallin.

8. Structure (1) selon l'une des revendications précédentes dans laquelle le substrat de base (3) présente une résistivité supérieure à 1000 ohm.centimètre, préférentiellement supérieure à 2000 ohm.centimètre.

9. Structure (1) selon l'une des revendications précédentes dans laquelle la couche de piégeage (3) est formée d'une couche de silicium polycristallin.

10. Structure (1) selon l'une des revendications précédentes dans laquelle la couche de piégeage (3) présente une épaisseure inférieure à 1 micron.

11. Structure (1) selon la revendication précédente dans laquelle la couche de piégeage (3) présente une épaisseur inférieure à 500nm.

12. Structure (1) selon l'une des revendications précédentes dans laquelle la couche mince (5) ferroélectrique porte des filtres à onde acoustique de surface.

13. Structure (1) selon l'une des revendications précédentes se présentant sous la forme d'une plaquette circulaire.
